Europäisches Patentamt

European Patent Office

Office européen des brevets

(11) Publication number: **0 045 181**

**B1**

(12) **EUROPEAN PATENT SPECIFICATION**

(45) Date of publication of patent specification: **15.05.85**

(51) Int. Cl.[4]: **H 01 L 21/203,** H 01 L 29/205, C 30 B 25/02

(21) Application number: **81303365.1**

(22) Date of filing: **23.07.81**

(54) **High electron mobility heterojunction semiconductor device and method of manufacturing.**

(30) Priority: **28.07.80 JP 103422/80**

(43) Date of publication of application: **03.02.82 Bulletin 82/05**

(45) Publication of the grant of the patent: **15.05.85 Bulletin 85/20**

(84) Designated Contracting States: **DE FR GB NL**

(56) References cited:
US-A-4 194 935

APPLIED PHYSICS LETTERS, vol. 33, no. 7, 1 october 1978, New York, R. DINGLE et al. "Electron mobilities in modulation-doped semiconductor heterojunction superlattices"
APPLIED PHYSICS LETTERS, vol. 37, no. 9, 1 november 1980, New York, S. HIYAMIZU et al. "High mobility of two-dimensional electrons at the GaAs/n-A1GaAs heterojunction interface"
APPLIED PHYSICS LETTERS, vol. 37, no. 11, 1 december 1980, New York, L.C. WITKOWSKI et al. "High mobilities in A1xGa1-xAs-GaAs heterojunctions"

(73) Proprietor: **FUJITSU LIMITED**
1015, Kamikodanaka Nakahara-ku Kawasaki-shi Kanagawa 211 (JP)

(72) Inventor: **Hiyamizu, Satoshi**
1-21-15, Izumihonmachi
Komae-shi Tokyo, 201 (JP)
Inventor: **Fujii, Toshio**
1-7-305, Nijigaoka 3-chome Tama-ku
Kawasaki-shi Kanagawa, 215 (JP)

(74) Representative: **Sunderland, James Harry et al**
HASELTINE LAKE & CO Hazlitt House 28
Southampton Buildings Chancery Lane
London WC2A 1AT (GB)

Courier Press, Leamington Spa, England.

# Description

This invention relates to a high electron mobility heterojunction semiconductor device.

A semiconductor device of this type utilizes electrons accumulated in the neighborhood of a single heterojunction as a result of a difference in electron affinity between two different kinds of semiconductors which form or interleave the single heterojunction therebetween.

More particularly, this invention relates to a high electron mobility transistor (hereinafter referred to as "HEMT") which is a type of FET.

A HEMT is an active semiconductor device of which the conductive channel consists of electrons accumulated at a (quasi-) two-dimensional surface contiguous with a single heterojunction formed or interleaved between one layer of a semiconductor (e.g. AlGaAs) having a lesser electron affinity and another layer of semiconductor (e.g. GaAs) having a larger electron affinity.

One example of a HEMT is a FET having a layer configuration consisting of an n-type AlGaAs layer grown on an updoped GaAs layer itself grown on a Cr-doped GaAs substrate having a large resistance, a Schottky barrier type gate electrode, and a pair of (source and drain) electrodes in ohmic contact with a conductive channel which is (quasi-) two-dimensional electron gas accumulated in the undoped GaAs layer in the form of plane very closely contiguous with a single heterojunction formed or interleaved between the n-type AlGaAs layer and the undoped GaAs layer.

The outstanding feature of a HEMT is the extremely large electron mobility which becomes available for the conductive channel or the two-dimensional electron gas at cryogenic temperatures, e.g. 4°K to 77°K. Since the thickness of this conductive channel or two-dimensional electron gas is extremely small, specifically less than 10 mm (100 Å), despite the fact that it is accumulated in the undoped GaAs layer in the form of plane contiguous with the single heterojunction of the n-type AlGaAs layer and the undoped GaAs layer, the conductive channel or the two-dimensional electron gas has a geometrical position separate from the n-type AlGaAs layer which is responsible for supplying electrons to the two-dimensional electron gas. Therefore, the mobility of electrons constituting the two-dimensional electron gas is free from the effects of ionized-impurity scattering.

It is well-known that ionized-impurity scattering is the major factor operating to prevent electron mobility increasing at cryogenic temperatures. Since ionized-impurity scattering has no effect on the magnitude of electron mobility in the two-dimensional electron gas, electron mobility becomes extremely large therein at cryogenic temperatures at which ionized-impurity scattering is inherently the major factor operating to prevent electron mobility from increasing. The results of experiments show that the magnitude of the improvement in electron mobility is more than 10.

Since the n-type AlGaAs layer supplies electrons to the two-dimensional electron gas, the n-type AlGaAs layer is depleted to some extent. When thicknesses and impurity concentrations, the magnitude of the Schottky barrier of the gate, and the difference between the electron affinity of a semiconductor (n-type AlGaAs in this case) which supples electrons to the two-dimensional electron gas and the electron affinity of the other semiconductor (undoped GaAs in this case) in which the two-dimensional electron gas is accumulated are properly selected, it is possible to deplete entirely the n-type AlGaAs layer. This is because the depletion layer caused by the Schottky barrier gate and the depletion layer caused by the movement of electrons to the two-dimensional electron gas due to the difference in electron affinities of AlGaAs and GaAs contact one another under thermal equilibrium. Since the undoped GaAs is nonconductive, the two-dimensional electron gas functions as the sole channel for the layer configuration described above. Further, when a voltage is applied to the gate electrode, the electron concentration of the two-dimensional electron gas can readily be modulated, thereby an FET having a layer configuration as described above can have a large magnitude of transfer conductance Gm.

The inventors of the present invention discovered the fact that the magnitude of electron mobility in the two-dimensional electron gas is sizably decreased by heat treatment or annealing applied to a high electron mobility semiconductor device. They assume this undesirable decrease in electron mobility to be caused by the effect of ionized-impurity scattering by impurities, for example Si, diffused into the semiconductor layer in which the two-dimensional electron gas is accumulated, undoped GaAs in the example above, from the semiconductor layer which supplies electrons to the two-dimensional electron gas, n-type AlGaAs in this case, during the heat treatment or annealing process. A publicly known method effective to prevent unexpected diffusion of impurities from occurring during the growth period of semiconductor layers is to interleave an undoped layer between two layers which have respective different magnitudes of impurity concentration. However, it would be impossible perfectly to prevent impurities from diffusing into the undoped GaAs layer from the n-type AlGaAs layer by these means.

In addition, the results of experiments carried out by inventors of the present invention show that not only an n-type impurity such as Si, which is assumed to have diffused from the n-type AlGaAs layer, but also an impurity which produces a deep level, such as Cr, is contained in the undoped GaAs layer. Since this impurity uniformly spreads through the entire 1-μm thickness of the undoped GaAs layer, it would be impossible to prevent this type of impurity diffusion from occurring, unless some layer configuration other than that of the example above is employed.

Further, it is widely recognized that it is not easy to grow a ternary or quaternary semiconductor layer. It is also widely recognized that a molecular beam epitaxy process or an ion beam epitaxy process is most appropriate for the purpose of growing a ternary or quaternary semiconductor layer, because each of those processes allows production of an abrupt heterojunction, and accurate control of thickness and of doping concentration. However, it is not necessarily easy to control accurately the composition of such a compound semiconductor. Unfortunately, however, control of the composition of AlGaAs and GaAs layers is extremely important insofar as the production of HEMT's is concerned, because composition is a parameter determining the quality of an HEMT. Further, ion beam epitaxy requires a heat treatment or annealing step.

US—A—4 194 935 discloses a multichannel high electron mobility semiconductor device. A multilayered structure is provided in which narrow bandgap semiconductor layers (e.g. of undoped GaAs) alternate with wide bandgap semiconductor layers (e.g. of n-doped AlGaAs) to form a multiplicity of functional heterojunctions, at which electrons accumulate, between those layers.

The wide bandgap semiconductor layers, primarily of n-doped AlGaAs, may have thin undoped zones contiguous to the heterojunctions.

Similar provisions are disclosed in Applied Physics Letters, Vol. 33, No. 7, 1 October 1978, in an article by R. Dingle et al at pages 665 to 667.

According to the present invention there is provided a high electron mobility heterojunction semiconductor device comprising:

a semi-insulating semiconductor substrate,

a binary semiconductor layer above the semi-insulating semiconductor substrate, which binary semiconductor layer is updoped or doped to a lesser degree than the next mentioned layer,

a ternary or quaternary semiconductor layer above the binary semiconductor layer, forming a heterojunction with the binary semiconductor layer, at least a part of which ternary or quaternary semiconductor layer is doped with an n-type impurity so that an electron accumulation layer is formed within the binary semiconductor layer along the heteojunction, this electron accumulation layer functioning as a conductive channel of the device,

characterised in that an undoped buffer layer of the same semiconductor as that of the ternary or quaternary semiconductor layer is provided between the binary semiconductor layer and the substrate, that the undoped buffer layer forms a second heterojunction with the ternary or quaternary semiconductor layer without an electron accumulation layer being formed along the second heterojunction.

According to the present invention there is also provided a method of manufacturing a high electron mobility heterojunction semiconductor device comprising:

growing, above a semi-insulating semiconductor substrate, a binary semiconductor layer, consisting of elements making up the next mentioned layer, being undoped, or doped to a lesser degree than the next mentioned layer,

growing a ternary or quaternary semiconductor layer on the binary semiconductor layer to form a heterojunction with the binary semiconductor layer, at least a part of which ternary or quaternary semiconductor layer is doped with an n-type impurity for forming an electron accumulation layer within the binary semiconductor layer along the heterojunction, the electron accumulation layer functioning as a conductive channel of the device,

characterised by growing an undoped buffer layer of the same semiconductor as the ternary or quaternary semiconductor layer, above the substrate, before the binary semiconductor layer is grown, so that the binary semiconductor layer is grown on the undoped buffer layer to form therewith a second heterojunction along which no electron accumulation layer is formed, the binary semiconductor layer.

An embodiment of the present invention can provide a HEMT having a layer configuration with an n-type AlGaAs layer grown on an updoped GaAs layer, to form a heterojunction therebetween, to allow electrons to be accumulated contiguously with the heterojunction in the undoped GaAs layer, the HEMT having a high magnitude of electron mobility even after an annealing process has been applied thereto.

An embodiment of the present invention can provide a method for production of a HEMT having a layer configuration as just mentioned above, the method offering improved control of the composition of ternary and/or quaternary compound semiconductors, more particularly of the n-type AlGaAs layer.

An embodiment of this invention can provide a method for production of a HEMT having the layer configuration just mentioned above, the method allowing employment of ion implantation process.

An embodiment of the present invention can provide a HEMT FET having an undoped, or at least not intentionally doped, GaAs layer and an n-type AlGaAs layer with a single functional heterojunction formed therebetween and allowing electrons with high mobility to be accumulated in the undoped, or at least not intentionally doped, GaAs layer in the form of a quasi-two-dimensional electron gas appearing contiguous with the single functional heterojunction, due to the difference in electron affinity between GaAs and AlGaAs, thereby the accum-ulated electrons in the form of a quasi-two-dimensional electron gas with high mobility function as the sole carriers or conductive channels of the FET's. Further, an embodiment of this invention can provide for an improved method for production of HEMT's described above.

A HEMT embodying the present invention is provided with an undoped AlGaAs layer interleaved between an undoped GaAs layer, on which an n-type AlGaAs layer is grown to supply electrons to a two-dimensional electron gas, which is accumulated contiguously with the heterojunction formed between the n-type AlGaAs layer and the undoped GaAs layer, which functions as the conductive channel of this HEMT, and a semi-insulating GaAs substrate, for example a n-doped GaAs substrate (or a buffer layer on the substrate).

The undoped AlGaAs layer has functions including (a) acting as a getter for a deep level impurity such as Cr which may be diffused from the Cr-doped GaAs substrate during one or more annealing processes employed in the manufacture of the HEMT, (b) acting as a buffer connecting the semi-insulating substrate and the undoped GaAs layer in which the two-dimensional electron gas is accumulated, and (c) acting as a type of test layer grown for the purpose of predetermining the intensity of each ingredient molecular beam or ion beam for the ultimate purposes of controlling the composition of the n-type AlGaAs layer which is scheduled to be grown later in the same continuous process for production of the HEMT.

A method of production of a HEMT in accordance with an embodiment of this invention comprises a step for growing an undoped AlGaAs layer on a semi-insulating GaAs substrate or a Cr-doped GaAs substrate (or on a buffer layer on the substrate), a step for growing an undoped GaAs layer on the undoped AlGaAs layer, and a step for growing an n-type AlGaAs layer having the same composition as the above described undoped AlGaAs layer, before one or more gate electrodes and source and drain electrodes are produced on the above described layer configuration.

The step for growing the undoped AlGaAs layer has functions including (a) a function for improving the crystal conditions of the undoped GaAs layer to be grown on the undoped AlGaAs layer (buffer effect), and (b) a function for providing a test layer grown for the purpose of predetermining the intensity of each ingredient molecular beam or ion beam, namely the quantities of Al, Ga, As and some dopants employed, for the ultimate purpose of providing accurate control of the composition of the n-type AlGaAs layer.

Incidentally, since the introduction of the undoped AlGaAs layer interleaved between the semi-insulating GaAs substrate (or a buffer layer on the substrate) and the undoped GaAs layer is effective to prevent an impurity with a deep level, such as Cr, from diffusing during a later annealing process, the employment of ion implantation processes for various purposes including adjustment of doping level of any semiconductor layer can be allowed.

Reference is made, by way of example, to the accompanying drawings, in which:—

Fig. 1 is a schematic sectional view illustrating the layer configuration of a wafer for a HEMT in accordance with an embodiment of this invention;

Fig. 2 is a schematic sectional view of a HEMT in accordance with an embodiment of this invention produced employing the wafer shown in Fig. 1; and

Fig. 3 is a graph comparing the magnitude of electron mobility offered by wafers having a layer configuration as provided in a HEMT in accordance with this invention and the magnitude of electron mobility offered by a wafer having a layer configuration as provided in a previously proposed HEMT.

In the following description, a MBE (molecular beam epitaxy) system or an IBE (ion beam epitaxy) system provided with equipment for measurement of molecular beam or ion beam intensity and for measurement of the internal gas pressure of a vacuum chamber is employed for production of a semiconductor layer configuration. For example, such equipment may be a quadrupole mass spectrometer (hereinafter referred to as a QMS) and a "nude" ion gauge (filament inserted uncovered—no glass cover tube—in the chamber where beam intensity is measured).

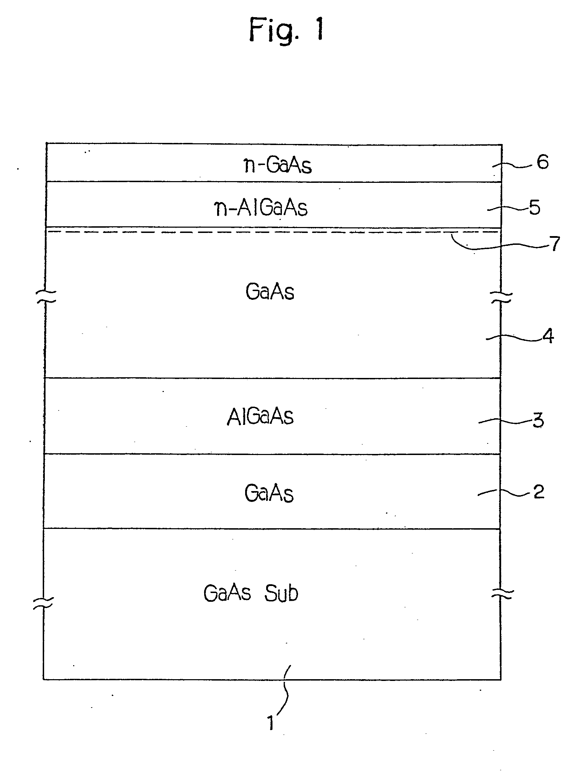

Referring to Fig. 1, an undoped GaAs layer 2 having a thickness of 100 nm (1,000 Å) is grown on a Cr-doped GaAs substrate 1. Layer 2 functions as a buffer. During the period in which this undoped GaAs layer 2 is grown, the internal pressure of the vacuum chamber is accurately controlled. In addition, a QMS and a nude ion gauge are employed to maintain control over the intensity of a Ga molecular or ion beam and the intensity of an As molecular or ion beam respectively to keep their intensities at minimum.

An undoped AlGaAs layer 3 having a ratio of Al vs. Ga of 3 vs. 7 and having a thickness of 100 nm (1,000 Å) is grown on the undoped GaAs layer 2. This undoped AlGaAs layer 3 is newly introduced in accordance with the embodiment of this invention. Though the layer 3 forms a heterojunction with the GaAs layer 2, no electron accumulation layer is formed along this heterojunction because the undoped layer 3 does not supply electrons. During the period in which this undoped AlGaAs layer 3 is grown, a QMS is employed to control the intensity of the Al molecular or ion beam and that of the Ga molecular or ion beam to realize an optimum ratio of Al to Ga in the product AlGaAs, under accurate control of the internal pressure of the vacuum vessel.

Thereafter, an undoped GaAs layer 4 having a thickness of 600 nm (6,000 Å), in which the two-dimensional electron gas 7 is accumulated when the finished device is in use, is grown on the undoped AlGaAs layer 3. During the period in which this undoped GaAs layer 4 is grown, a shutter is closed for the Al source, keeping the

temperature of the Al source or the intensity of the Al molecular or ion beam unchanged. Further, the intensity of Ga and As molecular or ion beams is kept unchanged. In other words, it is not necessary to change the intensity of any of the Al, Ga and As molecular or ion beams. The only action necessary to shift to this step from the previous step is closure of the shutter of the Al source. This is because that it is possible to grow a binary compound semiconductor without accurate control of the intensity of each ingredient molecular or ion beam.

An n-type AlGaAs layer 5 having a thickness of 60 nm (600Å), which is responsible for supplying electrons to the two-dimensional electron gas 7 which forms in the undoped GaAs layer 4 contiguous with the heterojunction between the n-type AlGaAs layer 5 and the undoped GaAs layer 4 when the finished device is in use, is grown. The ratio of Al vs. Ga is 3 vs. 7, as was in the case of the undoped AlGaAs layer 3. Si is doped to a concentration of $2 \times 10^{18}/cm^3$. The only action necessary to shift to this step from the previous step is to open the shutters of the Al source and an Si source, because the optimum conditions for the intensity of each ingredient molecular or ion beam have been maintained during the previous step. As a result, the composition of the n-type AlGaAs layer 5 is accurately controlled as expected from the beginning, thereby realizing a satisfactory quality of the heterojunction between the undoped GaAs layer 4 and the n-type AlGaAs layer 5. This is extremely important to realize a high electron mobility for the two-dimensional electron gas 7.

Although it is not shown in Fig. 1, it is preferable to leave a 5 nm (50Å) to 6 nm (60Å) portion of the AlGaAs layer 5 contiguous with the heterojunction undoped, because this is effective to prevent Si from diffusing into the undoped GaAs layer 4 from the n-type AlGaAs layer 5.

An n-type GaAs layer 6 having a thickness of 50 nm (500Å) is then grown. Since this layer is doped with Si to a concentration of about $2 \times 10^{18}/cm^3$, it is effective to produce ohmic contact with subsequently produced AuGe source and drain electrodes.

There will now be discussed below the reasons for and theoretical basis of the possibility of growing ternary or quaternary semiconductor layers of precise composition, particularly to maintain a good quality of one or more heterojunctions therebetween in a method embodying the present invention.

Of the parameters available in an MBE or IBE process, the intensity of each ingredient molecular or ion beam or the temperature of each source is most important for the precise control of composition of such compound semiconductors. Since the required intensity of each molecular or ion beam varies from one beam to another, the rates of depletion of the different beam sources are different from one another. Therefore, it is not easy to keep the sensitivity and/or accuracy of control of each molecular or ion beam uniformly in a good condition. It is well-known that the internal pressure of a vacuum chamber, the temperature of a substrate and the ratio of the magnitudes of intensity of molecular or ion beams are the important parameters for growing a binary compound semiconductor. In the case of ternary or quaternary semiconductors, the control of intensity of each molecular or ion beam is the most important parameter. Therefore, various means are implemented for MBE or IBE systems to meet the necessary standards. Namely, (a) preparation of a Knudsen cell with the optimum size, (b) arrangement of as many thermal sensors as possible at optimum positions to enable more precise control of the temperature of each source, and (c) employment of means for decreasing the effects of unstable surface positions of liquid sources.

However, it is particularly difficult to produce a heterojunction of a good quality between such ternary or quaternary semiconductors or between such a ternary or quaternary semiconductor and some other type of semiconductors. This is because it is difficult to control accurately the intensity of each ingredient molecular or ion beam particularly at the beginning of a growth step. Accordingly, in the case where a heterojunction is produced between a binary compound semiconductor layer and a ternary or quaternary semiconductor layer grown on the binary compound semiconductor, layer, growth of a test layer, in accordance with an embodiment of this invention, of a ternary or quaternary semiconductor identical to that which is to provide the upper layer of the heterojunction, prior to the step for growing the lower layer of the heterojunction (which lower layer is of binary compound semiconductor layer) is effective for providing that the composition of the ternary or quaternary semiconductor can be set as required.

The procedure is as follows:— (a) during the growth step for the lowest layer of a ternary or quaternary semiconductor, the intensity of each ingredient molecular or ion beam is accurately controlled by employment of a QMS and a nude ion gauge (b) during the growth step for the lower layer, of a binary compound semiconductor, supply of one or two sources is suspended, for example, by employment of one or more shutters, while the intensity of each igredient molecular or beam is maintained as adjusted in the first step, and (c) during the growth step for the upper layer of a ternary or quaternary semiconductor, supply of the suspended source is resumed. Since the intensity of each ingredient molecular or ion beam is maintained, during the second step, as adjusted in the first step, it is possible to produce the upper layer of a ternary or quaternary semiconductor having a composition as required from the beginning of production of that upper layer, thereby enabling production of a heterojunction with a good quality between the upper and lower layers.

Since the intensity of an Al molecular or ion beam is difficult to maintain at a specific level for a long time, this method is effective to produce ternary or quaternary semiconductors containing Al. Further, since the quality of the functional heterojunction between the n-type AlGaAs layer and the undoped GaAs layer has a decisive influence on the electron mobility of a HEMT, this method is effective for producing a HEMT of a better quality. In addition, the simplicity of the procedure provides inherent advantages.

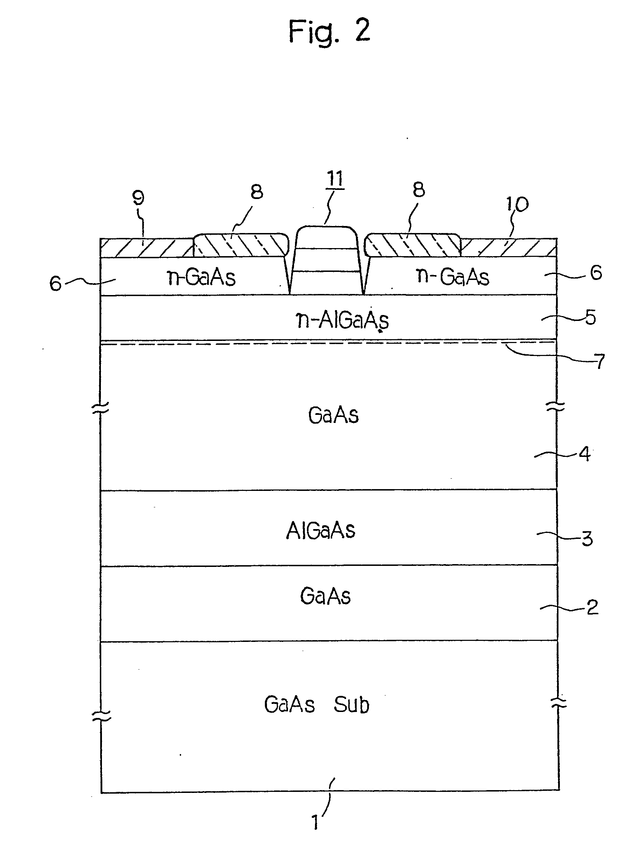

Referring to Fig. 2, an SiO₂ film 8 is produced on the top surface of the n-type GaAs layer 6, by a spattering process or the like. The SiO₂ film 8 is removed from areas where a source electrode and a drain electrode are to be produced. An AuGe film is produced on the top surface of the wafer, employing an evaporation process or the like. After the AuGe film has been patterned to the shapes of a source electrode 9 and a drain electrode 10, a heat treatment or annealing process is applied to the wafer for the purpose of ensuring ohmic contact between the source and drain electrodes 9 and 10 and the two-dimensional electron gas (or the conductive channel) 7 which is formed contiguous with the heterojunction, albeit that the alloyed regions formed (for such ohmic contact) are not shown on the Figure. An alternative to the AuGe film is a cumulative film of AuGe and Au. Thereafter, the SiO₂ film 8 and the n-type GaAs layer 6 are removed from an area where a gate electrode is to be produced. A cumulative film of Ti, Pt and Au is produced on the top surface of the wafer, employing successive evaporation processes or the like. The Ti/Pt/Au film is patterned to a shape of a gate electrode 11. A photoresist film employed for etching of the SiO₂ film 8 and the n-type GaAs layer 6 may be employed also for patterning of the gate electrode 11. In other words, the Ti/Pt/Au film could be produced on the top surface of the wafer on which the photoresist film remains, before the photoresist film and Ti/Pt/Au film thereon are concurrently removed.

Results of experiments show that the HEMT produced as described above has an improved electron mobility in comparison with previously available HEMT's.

Below, the results of an experiment carried out to confirm the advantage expected for this invention will be described.

The criteria of the experiment were as follows:—

(a) A number of specimen wafers are produced. The specimen wafers fall into two groups, one group consisting of wafers for HEMT's in accordance with the present invention, and the other group consisting of wafers for HEMT's not in accordance with this invention. Wafers of the former group have a layer configuration similar to that of the HEMT shown in Fig. 2; namely a layer configuration having 50 nm (500Å) n-type GaAs layer with an impurity concentration of about $2\times10^{18}/cm^3$ grown on a 54 nm (540-Å) n-type AlGaAs layer with almost the same amount of impurity concentration as described above, grown on a 6 nm (60-Å) undoped AlGaAs layer,

grown on a 400 nm (4,000-Å) undoped GaAs layer, grown on a 100 nm (1,000-Å) undoped AlGaAs layer, grown on a 100 nm (1,000-Å) undoped GaAs layer, grown on a 100 nm (1000-Å) undoped AlGaAs layer, grown on a 100 nm (1,000-Å) undoped GaAs layer, grown on a Cr-doped GaAs substrate. Wafers of the latter group have a layer configuration having a 50 nm (500-Å) n-type GaAs layer with an impurity concentration of about $2\times10^{18}/cm^3$, grown on a 54 nm (540-Å) n-type AlGaAs layer with almost the same amount of impurity concentration as described above, grown on a 6 nm (60-Å) undoped AlGaAs layer, grown on an 800 nm (8,000-Å) undoped GaAs layer, grown on a Cr-doped GaAs substrate.

(b) A 400—500 nm (4,000—5,000-Å) SiO₂ film is produced on the top surface of each specimen wafer produced as described above, employing a spattering process.

(c) Each specimen wafer undergoes heat treatment or an annealing process, in H₂ atmosphere for 15 minutes at various temperatures, 700°C to 790°C.

(d) Electron mobility of the two-dimensional electron gas and two-dimensional or sheet concentration of electrons (hereinafter referred to as "sheet electron concentration") accumulated contiguously with the heterojunction between the n-type AlGaAs layer and the undoped GaAs layer, due to the difference in electron affinity therebetween is measured for each specimen wafer at a cryogenic temperature, specifically 77°K.

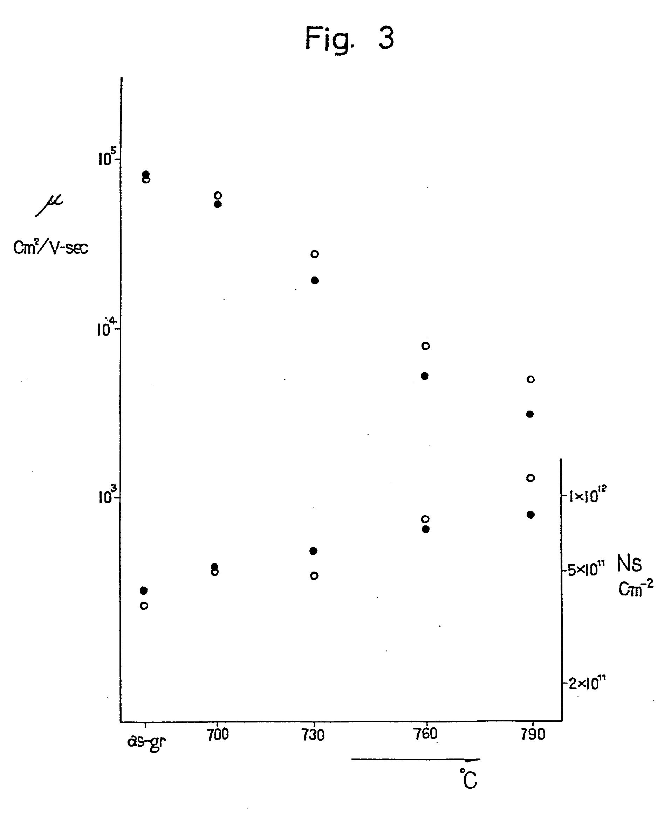

Fig. 3 is a graph showing the results of the experiment described above. Along the X-axis, annealing or heat treatment temperature is shown. Along the X-axis, "As-gr" stands for "as grown" and means that no annealing process was applied. Along the Y-axis, the demonstrated electron mobility μ and the sheet electron concentration Ns are shown. Open circles and solid circles respectively show the results for specimens representing HEMT's embodying this invention and the results for specimens representing HEMT's not embodying this invention.

Referring to Fig. 3, a tendency is observed that higher annealing temperature is accompanied by larger sheet electron concentration Ns and lesser electron mobility μ. This implies Si diffusion from the n-type AlGaAs layer to the undoped GaAs layer. Further observed is that there is no distinct difference in electron mobility of the "As-gr" specimens, but an increasing larger difference in electron mobility is observed for specimens annealed at increasingly higher temperatures. For example, specimens representing HEMT's in accordance with an embodiment of this invention have electron mobilities of 62,000 cm²/V-sec and 27,000 cm²/V-sec respectively when annealed at temperatures of 700°C and 730°C, whilst the corresponding mobilities for specimens representing HEMT's not in accordance with this invention decrease to 54,000 cm²/V-sec and 19,000 cm²/V-sec respectively.

This clearly demonstrates that the HEMT in accordance with an embodiment of this invention has a larger amount of electron mobility than the HEMT not in accordance with this invention, even after a heat treatment or annealing process is applied thereto, because an impurity having a deep level, such as Cr, is effectively prevented from diffusing into the undoped GaAs layer from the Cr-doped GaAs substrate due to the existence of an undoped AlGaAs layer.

The above described experimental results show that annealing processes can be introduced into methods for production of HEMT's, thus allowing ion implantation processes to be used for the purposes of control of a pinch-off voltage or a threshold voltage of a HEMT, production of ohmic contact for source and drain electrodes and the like.

An ion implantation process inevitably requires an annealing process, and the present invention is thus extremely useful in facilitating production of IC's containing HEMT's.

In other words, if an ion implantation process is employed for production of a HEMT having a layer configuration consisting of an n-type AlGaAs layer and an undoped GaAs layer, annealing in the temperature range above 700°C is required. If an annealing process in this temperature range is applied to a wafer having a layer configuration for production of a HEMT not in accordance with this invention, the electron mobility of the two-dimensional electron gas is considerably decreased, as a result destroying the features inherently required of a HEMT. However, in the case of a wafer for production of a HEMT in accordance with an embodiment of this invention, an annealing process in such a temperature range as described above has a less adverse effect on the electron mobility of the two-dimensional electron gas, safely maintaining the features and advantages inherently required of a HEMT.

The embodiments of the present invention described above have an undoped GaAs layer in which the two-dimensional electron gas is accumulated to provide a sole conductive channel for an HEMT. However, embodiments of the present invention can be provided with a p or n-doped GaAs layer for this purpose, insofar as the ratio of the impurity concentration thereof to that of the n-type AlGaAs layer is larger than $10^2$ (i.e. provided that the e.g., n-type doped GaAs has an impurity concentration sufficiently less, e.g., one hundred times less than the n-type AlGaAs). Therefore, this invention is applicable also to these cases.

It will be clear that an embodiment of this invention provides a HEMT having a layer configuration which allows heat treatment or annealing processes to be applied thereto without consequent diffusion of impurities which produce a deep level, such as Cr, into a layer of semiconductor having a larger electron affinity, and which therefore maintains a high electron mobility after such heat treatment or annealing processes. It will further be clear that an embodiment of this invention provides a method for production of such a layer configuration for a HEMT, the method offering improved control of the composition of the ternary and/or quaternary compound semiconductors used, for example n-type AlGaAs.

In addition, it will also be clear that such a layer configuration for an embodiment of this invention, which allows the use of annealing processes, additionally allows ion implantation processes to be introduced into a method for production of a HEMT.

It will be understood that an 'undoped' layer is free from intentional doping impurities but may contain unintentional doping impurities.

An embodiment of the present invention provides a high electron mobility single heterojunction semiconductor device having a layer configuration comprising of an n-type AlGaAs layer grown on an undoped GaAs layer, grown on an undoped AlGaAs layer grown on a semiconductor substrate containing an impurity producing a deep level. The undoped AlGaAs layer has functions including (a) acting as a getter for the deep level impurities which may be diffused from the substrate during an annealing process, (b) acting as a buffer for improving the crystal condition of the undoped GaAs layer, and (c) acting as a test layer grown for the purpose of predetermining the intensities of molecular or ion beams for Al, Ga and As and for dopants, e.g. Si. Annealing processes and ion implantation processes can be introduced to a method for production of this type of semiconductor device without reducing the electron mobility thereof.

An embodiment of the present invention provides a high electron mobility heterojunction semiconductor device comprising:

an undoped AlGaAs layer grown on a semi-insulating GaAs substrate,

a GaAs layer grown on said undoped AlGaAs layer, said GaAs layer having a less amount of N-type impurity concentration,

a n-type AlGaAs layer grown on said GaAs layer, interleaving a heterojunction between said GaAs layer and said n-type AlGaAs layer,

at least one gate electrode placed on said n-type AlGaAs layer, and

a pair of source and drain electrodes arranged across said at least one gate electrode.

An embodiment of the present invention provides a method for production of a high electron mobility single heterojunction semiconductor device comprising:

a step to grow an undoped ternary semiconductor layer on a semi-insulating substrate, employing any of a molecular beam epitaxy process and an ion beam epitaxy process,

a step to grow an undoped binary semiconductor layer on said undoped ternary semiconductor layer, employing any of a molecular beam epitaxy process and an ion beam epitaxy process, said undoped binary semiconductor layer being of a binary semiconductor consisting of two ingredient substances selected from the three ingredient substances consisting of said undoped ternary semiconductor layer,

a step to grow a layer of a ternary semiconductor identical to the semiconductor of said undoped ternary semiconductor layer, employing any of a molecular beam epitaxy process and an ion beam epitaxy process, said layer of a ternary semiconductor having a large amount of n-type impurity concentration,

a step to place at least one gate electrode on said layer of a ternary semiconductor, and

a step to arrange a pair of source and drain electrodes across said at least one gate electrode.

## Claims

1. A high electron mobility heterojunction semiconductor device comprising:

a semi-insulating semiconductor substrate,

a binary semiconductor layer above the semi-insulating semiconductor substrate, which binary semiconductor layer is undoped or doped to a lesser degree than the next mentioned layer,

a ternary or quaternary semiconductor layer above the binary semiconductor layer, forming a heterojunction with the binary semiconductor layer, at least a part of which ternary or quaternary semiconductor layer is doped with an n-type impurity so that an electron accumulation layer is formed within the binary semiconductor layer along the heterojunction, this electron accumulation layer functioning as a conductive channel of the device,

characterised in that an undoped buffer layer of the same semiconductor as that of the ternary or quaternary semiconductor layer is provided between the binary semiconductor layer and the substrate, so that the undoped buffer layer forms a second heterojunction with the binary semiconductor layer without an electron accumulation layer being formed along the second heterojunction.

2. A device as claimed in claim 1, characterised in that the n-type ternary or quaternary semiconductor layer is formed directly upon the binary semiconductor layer.

3. A device as claimed in claim 1, characterised in that an undoped region of the ternary or quaternary semiconductor is provided between the n-type ternary or quaternary semiconductor layer and the binary semiconductor layer.

4. A device as claimed in claim 1, 2 or 3, characterised in that a further binary semiconductor layer, undoped, is provided between the undoped buffer layer and the substrate.

5. A device as claimed in claim 1, 2, 3 or 4, characterised in that the binary semiconductor is GaAs, and the ternary or quaternary semiconductor is AlGaAs.

6. A device as claimed in claim 5, wherein the substrate is for example of GaAs, or is of Cr-doped GaAs.

7. A device as claimed in any preceding claim, comprising a gate electrode on top of the n-type ternary or quaternary semiconductor layer, and source and drain electrodes.

8. A method of manufacturing a high electron mobility heterojunction semiconductor device comprising:

growing, above a semi-insulating semiconductor substrate, a binary semiconductor layer, consisting of elements making up the next mentioned layer, being undoped, or doped to a lesser degree than the next mentioned layer,

growing a ternary or quaternary semiconductor layer on the binary semiconductor layer to form a heterojunction with the binary semiconductor layer, at least a part of which ternary or quaternary semiconductor layer is doped with an n-type impurity for forming an electron accumulation layer within the binary semiconductor layer along the heterojunction, the electron accumulation layer functioning as a conductive channel of the device,

characterised by growing an undoped buffer layer of the same semiconductor as the ternary or quaternary semiconductor layer, above the substrate, before the binary semiconductor layer is grown, so that the binary semiconductor layer is grown on the undoped buffer layer to form therewith a second heterojunction along which no electron accumulation layer is formed.

9. A method as claimed in claim 8, wherein the n-type ternary or quaternary semiconductor layer is grown directly upon the binary semiconductor layer.

10. A method as claimed in claim 8, wherein an undoped region of the ternary or quaternary semiconductor is grown on the binary semiconductor layer and the n-type ternary or quaternary semiconductor layer is grown thereon.

11. A method as claimed in claim 8, 9 or 10, wherein a further layer, of the binary semiconductor, is grown on the substrate, and then the undoped buffer layer is grown thereon.

12. A method as claimed in claim 8, 9, 10 or 11, wherein each layer is grown either by a molecular beam epitaxy process or an ion beam epitaxy process.

13. A method as claimed in claim 12, wherein, in the growth of the binary semiconductor layer, the beam or beams from the or those beam sources providing the element or elements of the ternary or quaternary semiconductor not of the binary semiconductor are cut off by means of a shutter or shutters, but intensity of the beam or beams from the beam sources are maintained during the growth of the binary semiconductor layer, and for the subsequent growth of the n-type ternary or quaternary semiconductor layer, the shutter or shutters are opened to allow the previously cut-off beams to pass.

14. A method as claimed in any one of claims 8 to 13, further comprising:—

growing a gate electrode on top of the n-type ternary or quaternary semiconductor layer, and

growing source and drain electrodes.

15. A method as claimed in claim 14, wherein an ion implantation processs is employed for at least one of the following steps:— growing a ternary or quaternary semiconductor layer, growing the gate electrode, growing the source and drain electrodes.

16. A method as claimed in any one of claims 8 to 15, wherein the ternary or quaternary semiconductor is AlGaAs and the binary semiconductor is GaAs.

**Revendications**

1. Composant semi-conducteur à hétérojonction à grande mobilité des électrons, comportant un substrat semi-conducteur semi-isolant, une couche semi-conductrice binaire au-dessus du substrat semi-conducteur semi-isolant, cette couche semi-conductrice binaire n'étant pas dopée ou étant dopée à un degré moindre que la couche mentionnée ensuite, une couche semi-conductrice ternaire ou quaternaire au-dessus de la couche semi-conductrice binaire, formant une hétérojunction avec la couche semi-conductrice binaire, au moins une partie de ladite couche semi-conductrice ternaire ou quaternaire étant dopée avec une impureté du type N de manière qu'une couche d'accumulation d'électrons soit formée dans la couche semi-conductrice binaire le long de l'hétérojonction, cette couche d'accumulation d'électrons fonctionnant comme un canal conducteur du composant, caractérisé en ce qu'une couche tampon non dopée du même semi-conducteur que celui de la couche semi-conductrice ternaire ou quaternaire est prévu entre la couche semi-conductrice binaire est prévue entre la couche semi-conductrice binaire de substrat de manière que la couche tampon non dopée forme une seconde hétérojonction avec la couche semi-conductrice binaire sans qu'une couche d'accumulation d'électrons soit formée le long de la seconde hétérojonction.

2. Composant selon la revendication 1, caractérisé en ce que la couche semi-conductrice ternaire ou quaternaire de type N est formée directement sur la couche semi-conductrice binaire.

3. Composant selon la revendication 1, caractérisé en ce qu'une région non dopée du semi-conducteur ternaire ou quaternaire est prévue entre la couche semi-conductrice ternaire ou quaternaire de type N de la couche semi-conductrice binaire.

4. Composant selon l'une des revendications 1, 2 ou 3, caractérisé en ce qu'une autre couche semi-conductrice binaire non dopée est prévue entre la couche tampon non dopée et le subtrat.

5. Composant selon l'une des revendications 1, 2, 3 et 4 caractérisé en ce que le semi-conducteur binaire est du GaAs et le semi-conducteur ternaire ou quaternaire est du AlGaAs.

6. Composant selon la revendication 5, dans lequel le substrat est par exemple du GaAs, ou du GaAs dopée de Cr.

7. Composant selon l'une quelconque des revendications précédentes, comprenant une électrode grille sur le dessus de la couche semi-conductrice ternaire ou quaternaire de type N et des électrodes de source de drain.

8. Procédé de fabrication d'un composant semi-conducteur à hétérojonction à grande mobilité d'électrons, consistant à faire croître, au-dessus d'un substrat semi-conducteur et semi isolant, une couche semi-conductrice binaire consistant en des éléments formant la couche mentionnée ensuite, non dopée ou dopée à un degré moindre que la couche mentionnée ensuite, à faire croîtie une couche semi-conductrice ternaire ou quaternaire sur la couche semi-conductrice binaire pour former une hétérojonction avec la couche semi-conductrice binaire, au moins une partie de la couche semi-conductrice ternaire ou quaternaire étant dopée avec une impureté du type N pour former une couche d'accumulation d'électrons dans la couche semi-conductrice binaire le long de l'hétérojonction, la couche d'accumulation d'électrons fonctionnant comme un canal conducteur du composant, procédé caractérisé en ce qu'il consiste à faire croître une couche tampon non dopée du même semi-conducteur que la couche semi-conductrice ternaire ou quaternaire au-dessus du substrat avant que la couche semi-conductrice binaire soit formée par croisance; de manière que la couche semi-conductrice binaire soit formée par croissance sur la couche tampon non dopée pour former avec elle une seconde hétérojonction le long de laquelle aucune d'accumulation d'électrons n'est formée.

9. Procédé selon la revendication 8, dans lequel, la couche semi-conductrice ternaire ou quaternaire de type N est formée par croissance directement sur la couche semi-conductrice binaire.

10. Procédé selon la revendication 8, dans lequel une région non dopée du semi-conducteur ternaire ou quaternaire est formée par croissance sur la couche semi-conductrice binaire et la couche semi-conductrice ternaire ou quaternaire de type N est formée par croissance au-dessus.

11. Procédé selon l'une des revendications 8, 9 et 10, dans lequel une autre couche du semi-conducteur binaire est formée par croissance sur le substrat et ensuite, la couche tampon non dopée est formée par croissance au-dessus.

12. Procédé selon l'une des revendications 8, 9, 10 ou 11, dans lequel chaque couche est formée par croissance, par un procédé épitaxial à faisceaux moléculaires ou un procédé épitaxial à faisceaux ioniques.

13. Procédé selon la revendication 12, dans lequel dans la croissance de la couche semi-conductrice binaire, le faisceau ou les faisceaux d'une ou plusiers sources de faisceaux produisant l'élément ou les éléments du semi-conducteur ternaire ou quaternaire et non du semi-conducteur binaire sont interrompus par un ou plusieurs obturateurs, mais l'intensité du faisceau ou des faisceaux des sources de faisceaux étant maintenue pendant la croissance de la couche semi-conductrice binaire et, pour la croissance suivant de la couche semi-conductrice ternaire ou quaternaire de type N, l'obturateur ou les obturateurs étant ouverts pour permettre le passage des faisceaux précédemment interrompus.

14. Procédé selon l'une quelconque des revendications 8 à 13, consistant en outre à faire croître une électrode de grille sur le dessus de la couche semi-conductrice ternaire ou quaternaire de type N et à faire croître des électrodes de source et de drain.

15. Procédé selon la revendication 14, dans lequel un procédé d'implantation d'ions est utilisé pour l'une au moins des phases suivantes:— croissance d'une couche semi-conductrice ternaire ou quaternaire, croissance de l'électrode de grille, croissance des électrodes de source et de drain.

16. Procédé selon l'une quelconque des revendications 8 à 15, dans lequel le semi-conducteur ternaire ou quaternaire est du AlGaAs et le conducteur binaire est du GaAs.

**Patentansprüche**

1. Halbleiterbauelement mit Heteroübergang und hoher Elektronenbeweglichkeit, mit:
einem halbisolierenden Halbleitersubstrat,
einer oberhalb des halbisolierenden Halbleitersubstrats angeordneten binären Halbleiterschicht, welche undotiert oder in einem geringeren Grade als die nächste genannte Schicht dotiert ist,
einer ternären oder quaternären Halbleiterschicht, oberhalb der binären Halbleiterschicht, die mit der binären Halbleiterschicht einen Heteroüergang bildet, wobei wenigstens ein Teil der ternären oder quaternären Halbleiterschicht mit einer Verunreinigung vom n-Typ so dotiert ist, daß eine Elektronenansammlungsschicht innerhalb der binären Halbleiterschicht längs des Heteroüberganges gebildet wird und diese Elektronenansammlungsschicht als leitender Kanal für die Vorrichtung dient,
dadurch gekennzeichnet, daß eine undotierte Pufferschicht desselben Halbleiters wie der ternären oder quaternären Halbleiterschicht zwischen der binären Halbleiterschicht und dem Substrat vorgesehen ist, so daß die undotierte Pufferschicht einen zweiten Heteroübergang mit der binären Halbleiterschicht bildet, ohne daß eine Elektronenansammlungsschicht längs des zweiten Heteroüberganges gebildet wird.

2. Vorrichtung nach Anspruch 1, dadurch gekennzeichnet, daß die ternäre oder quaternäre Halbleiterschicht vom n-Typ direkt auf der binären Halbleiterschicht gebildet ist.

3. Vorrichtung nach Anspruch 1, dadurch gekennzeichnet, daß ein undotierter Bereich des ternären oder quaternären Halbleiters zwischen der ternären oder quaternären Halbleiterschicht vom n-Typ und der binären Halbleiterschicht vergesehen ist.

4. Vorrichtung nach Anspruch 1, 2 oder 3, dadurch gekennzeichnet, daß eine weitere binäre Halbleiterschicht, undotiert, zwischen der undotierten Pufferschicht und dem Substrat vorgesehen ist.

5. Vorrichtung nach Anspruch 1, 2, 3 oder 4, dadurch gekennzeichnet, daß der binäre Halbleiter GaAs und der ternäre oder quaternäre Halbleiter AlGaAs ist.

6. Vorrichtung nach Anspruch 5, bei welcher das Substrat z. B. GaAs oder Cr-dotiertes GaAs ist.

7. Vorrichtung nach einem der vorhergehenden Ansprüche, mit einer Gateelektrode oben auf der ternären oder quaternären Halbleiterschicht vom n-Typ, und mit Source- und Drainelektroden.

8. Verfahren zur Herstellung einer Halbleitervorrichtung mit Heteroübergang und hoher Elektronenbeweglichkeit bei dem
auf einem halbisolierenden Halbleitrsubstrat eine binäre Halbleiterschicht aufgewachsen wird, welche aus Elementen besteht, die die nächste genannte Schicht ausmachen, und undotiert oder in einem geringeren Grad als die nächstgenannte Schicht dotiert ist,
und auf der binären Halbleiterschicht eine ternäre oder quaternäre Halbleiterschicht aufgewachsen wird, un einen Heteroübergang mit der binären Halbleiterschicht zu bilden, wobei wenigstens ein Teil der ternären oder quaternären Halbleiterschicht mit Verunreinigungen vom n-Typ dotiert ist, um eine Elektronenansammlungsschicht innerhalb der binären Halbleiterschicht längs des Heteroüberganges zu bilden, wobei die Elektronenansammlungsschicht als leitender Kanal der Vorrichtung funktioniert,
dadurch gekennzeichnet, daß eine undotierte Pufferschicht aus demselben Halbleiter wie die ternäre oder die quaternäre Halbleiterschicht über dem Substrat aufgewachsen wird, bevor die binäre Halbleiterschicht aufgewachsen wird, so daß die binäre Halbleiterschicht auf der undotierten Pufferschicht aufgewachsen wird, un mit dieser einen zweiten Heteroübergang zu bilden, längs welchem keine Eketronenansammlungsschicht gebildet wird.

9. Verfahren nach Anspruch 8, bei welchem die ternäre oder quaternäre Halbleiterschicht vom n-Typ direkt auf der binären Halbleiterschicht aufgewachsen wird.

10. Verfahren nach Anspruch 8, bei welchem ein undotierter Bereich von dem ternären oder quaternären Halbleiter auf der binären Halbleiterschicht aufgewachsen wird und die ternäre oder quaternäre Halbleiterschicht vom n-Typ derauf aufgewachsen wird.

11. Verfahren nach Anspruch 8, 9 oder 10, bei welchem eine weitere Schicht aus binärem Halbleiter auf dem Substrat aufgewachsen wird und dann die undotierte Schicht auf dieser aufgewachsen wird.

12. Verfahren nach Anspruch 8, 9, 10 oder 11, bei welchem jede Schicht entweder durch ein Molekular-Epitaxieverfahren oder durch ein Ionenstrahl-Epitaxieverfahren gewachsen wird.

13. Verfahren nach Anspruch 12, bei welchem, beim Aufwachsen der binären Halbleiterschicht der Strahl oder die Strahlen von dem oder den Strahlungsquellen, welche das Element oder die Elemente von dem ternären oder quaternären Halbleiter, nicht von dem binären Halbleiter, liefern, mit Hilfe eines Verschlusses oder von Verschlüssen abgeschnitten werden, jedoch die Intensität des Strahls oder der Strahlen von den Strahlenquellen während des Wachstums der binären Halbleiterschicht aufrechterhalten wird, und während des folgeenden Wachstums der ternären oder quaternären Halbleiterschicht vom n-Typ, der Verschluß oder die Verschlüsse geöffnet werden, um zu erlauben, daß die zuvor abgeschnitten Strahlen hindurchgelangen können.

14. Verfahren nach einem der Ansprüche 8 bis 13, ferner gekennzeichnet durch das Aufwachsen einer Gateelektrode auf der Oberseite der ternären oder quaternären Halbleiterschicht vom n-Typ und das Aufwachsen von Source- und Drainelektroden.

15. Verfahren nach Anspruch 14, bei welchem ein Ionenimplantationsverfahren für wenigstens einen der folgenden Schritte verwendet wird:— Aufwachsen einer ternären oder quaternären Halbleiterschicht, Aufwachsen der Gateelektrode, Aufwachsen der Sourceoder Drainelektroden.

16. Verfahren nach einem der Ansprüche 8 bis 15, bei welchem der ternäre oder quaternäre Halbleiter AlGaAs und der binäre Halbleiter GaAs sind.

11

# Fig. 1

| | |
|---|---|
| n-GaAs | 6 |
| n-AlGaAs | 5 |
| | 7 |
| GaAs | 4 |
| AlGaAs | 3 |
| GaAs | 2 |
| GaAs Sub | |

1

# Fig. 2

# Fig. 3